# EUROPÄISCHE PATENTSCHRIFT

(11) **EP 2 516 695 B1**
(45) Veröffentlichungstag und Bekanntmachung des Hinweises auf die Patenterteilung: **22.03.2017**
(21) Anmeldenummer: 10798272.0
(22) Anmeldetag: 22.12.2010
(51) Int. Cl.: C23C 16/56, C23C 14/58, C23C 14/00, C25D 11/02, C25D 11/18, C23C 16/00, C23C 28/00, C23C 28/02

(54) **BESCHICHTETES WERKZEUG**
COATED TOOL
OUTIL REVÊTU

(30) Priorität: 28.01.2010 DE 102010005977; 22.12.2009 DE 102009060402
(43) Veröffentlichungstag der Anmeldung: 31.10.2012
(73) Patentinhaber: Gühring oHG, 72458 Albstadt (DE)
(72) Erfinder: FIEDLER, Mario, 13125 Berlin (DE)
(74) Vertreter: Meitinger, Thomas Heinz
(86) Internationale Anmeldenummer: PCT/EP2010/007893
(87) Internationale Veröffentlichungsnummer: WO 2011/085796

(56) Entgegenhaltungen:
- EP-A1- 1 484 428
- WO-A1-2004/087994
- DE-A1- 4 000 664
- JP-A- H05 271 907
- US-A- 3 616 279
- US-A1- 2006 169 592
- TOSHIAKI OHTSUKA ET AL: "Cathodic Reduction of Anodic Oxide Films Formed on Titanium", JOURNAL OF THE ELECTROCHEMICAL SOCIETY, ELECTROCHEMICAL SOCIETY, vol. 134, no. 10, 1 October 1987 (1987-10-01), pages 2406-2410, XP002637906, ISSN: 0013-4651, DOI: 10.1149/1.2100212

## Beschreibung

### GEBIET DER ERFINDUNG

Die vorliegende Erfindung betrifft ein Werkzeug oder einen Rohling und ein Verfahren zur Herstellung eines Werkzeugs oder eines Rohlings.

### HINTERGRUND DER ERFINDUNG

Im Stand der Technik sind Verfahren zur Beschichtung von Werkzeugen zur Reduzierung des Verschleißes bzw. zum Korrosionsschutz bekannt.

TOSHIAKI OHTSUKA ET AL: "Cathodic Reduction of Anodic Oxide Films Formed on Titanium", JOURNAL OF THE ELECTROCHEMICAL SOCIETY, ELECTROCHEMICAL SOCIETY, Bd. 134, Nr. 10, 1. Oktober 1987 (1987-10-01), Seiten 2406-2410, XP002637906, ISSN: 0013-4651, DOI: 10.1149/1.2100212 offenbart Farbveränderungen in teilreduzierte Titanoxidschichten.

US 2006/169592 A1 offenbart einen Rohling mit einer 5 nm Aluminiumschicht, einer 6.5 nm Oxidschicht (30) und darüber eine Aluminiumschicht (40).

### ZUSAMMENFASSUNG DER ERFINDUNG

Werkzeuge oder Rohlinge unterliegen teilweise einem sehr komplizierten Herstellungsprozess, der mehrere Schritte umfassen kann. Diese Schritte sollten dokumentiert werden, um unnötige Doppelarbeiten bzw. das versehentliche Auslassen eines Bearbeitungsschritts zu vermeiden. Ferner können sich Werkzeuge für unterschiedliche Arbeitsprozesse rein optisch in ihrer Geometrie, z.B. Bohrgeometrie, kaum unterscheiden, wodurch diese Unterschiede ohne spezielle Hilfsmittel nur schwer erkennbar sein können. Hierdurch besteht die Gefahr, dass bei einem Arbeitsprozess das falsche Werkzeug eingesetzt wird, z.B. ein Gewindeschneidwerkzeug einer falschen Schneidstufe oder ein Stufenbohrer einer falschen Stufe.

Ferner können Rohlinge aus unterschiedlichen Materialien, wie z.B. Werkzeugstählen, Hartmetallen, Cermets oder ähnlichen bestehen, was optisch schwer oder nicht erkennbar ist. Hierdurch können sich Verwechslungen bei der weiteren Bearbeitung der Rohlinge ergeben.

Es kann daher als eine Aufgabe der vorliegenden Erfindung betrachtet werden, Werkzeuge und/oder Rohlinge zu kennzeichnen bzw. zu kodieren, um verschiedene Herstellschritte zu dokumentieren bzw. optisch ähnliche Werkzeuge, die aber für verschiedene Aufgaben vorgesehen sind, bzw. Werkzeuge und/oder Rohlinge aus unterschiedlichen Materialien leichter unterscheiden zu können.

Diese Aufgabe wird in den unabhängigen Ansprüchen gelöst. Weitere vorteilhafte Ausgestaltungen der Erfindung ergeben sich aus den Unteransprüchen.

Als erste Ausführungsform wird ein Werkzeug oder ein Rohling zur Verfügung gestellt, wobei das Werkzeug oder der Rohling umfasst: eine erste Schicht, herstellbar durch ein erstes Verfahren und eine zweite Schicht, herstellbar durch ein zweites Verfahren, wobei die zweite Schicht über der ersten Schicht angeordnet ist und wobei das erste Verfahren unterschiedlich zum zweiten Verfahren ist.

Durch das Beschichten eines Werkzeugs mit mehreren Schichten, wobei zumindest zwei unterschiedliche Verfahren eingesetzt werden, können Werkzeuge mit mehreren (und nicht nur einzelnen) vorteilhaften Eigenschaften hergestellt werden. Insbesondere können hierdurch Werkzeuge mit erhöhter Abriebfestigkeit und/oder besserem Korrosionsschutz erhalten werden, die zusätzlich farblich gekennzeichnet sein können.

Die Werkzeuge können dabei als letzte Arbeitsschritte beschichtet werden. Eine Beschichtung kann auch zwischen aufeinanderfolgenden Herstellschritten des Werkzeugs erfolgen. Auch können bereits die Rohlinge beschichtet werden, um nach Beendigung entsprechender Herstellschritte (zumindest teilweise) beschichtete Werkzeuge zu erhalten.

Als zweite Ausführungsform wird ein Verfahren zur Herstellung eines Werkzeugs oder eines Rohlings zur Verfügung gestellt, wobei das Verfahren die Schritte umfasst: Beschichten des Werkzeugs oder des Rohlings mit einer ersten Schicht herstellbar durch ein erstes Verfahren und Beschichten oder Nachbehandeln oder Modifizieren des Werkzeugs oder des Rohlings mit einer zweiten Schicht herstellbar durch ein zweites Verfahren, wobei das erste Verfahren unterschiedlich zum zweiten Verfahren ist.

Beispielhafte Ausführungsformen werden in den abhängigen Ansprüchen beschrieben.

Gemäß einer beispielhaften Ausführungsform wird ein Werkzeug oder ein Rohling zur Verfügung gestellt, wobei das erste Verfahren ein Verfahren aus einer Gruppe von Verfahren ist, wobei die Gruppe umfasst: PVD-Verfahren, CVD-Verfahren und elektrophoretische Verfahren und/oder wobei das zweite Verfahren eine anodische Oxidation ist.

In einer weiteren Ausführungsform wird ein Werkzeug oder ein Rohling zur Verfügung gestellt, wobei die erste Schicht eine Metallschicht ist und die zweite Schicht eine Oxidschicht ist.

Erfindungsgemäß kann ein Werkzeug zunächst durch ein PVD-Verfahren beispielsweise mit einer Metallschicht versehen werden. Diese Metallschicht kann in einem weiteren Verfahrensschritt anodisch oxidiert werden, wodurch sich eine Oxidschicht ergibt. Es kann auch eine weitere Schicht, z.B. eine Hartstoffschicht oder eine Metallschicht, zwischen dem Substrat und den zuvor genannten beiden Schichten angeordnet werden, wodurch sich ein Werkzeug ergibt, das außerdem eine Verschleißschutzschicht und/oder Korrosionsschutzschicht aufweist. Ferner kann das Werkzeug durch die Oxidschicht einen Farbton aufweisen, der zur Codierung bzw. Dokumentation von Herstellschritten, Arbeitsprozessen oder Eigenschaften des Werkzeugs, wie z.B. Werkzeugstahl, Bohrgeometrie, etc., dienen kann. Dieser Farbton kann durch nachträgliche kathodische Reduktion oder Teilreduktion durch Variation der am Elektrolyt angelegten Spannung nachträglich beliebig oft verändert werden, wodurch am Werkzeug auch sich wiederholende Bearbeitungsschritte, wie z.B. mehrmaliges Nachschleifen, dokumentiert werden können.

Gemäß einem weiteren Ausführungsbeispiel wird ein Werkzeug oder ein Rohling zur Verfügung gestellt, wobei das Werkzeug oder der Rohling umfasst: eine dritte Schicht, herstellbar durch eine kathodische Reduktion oder Teilreduktion der zweiten Schicht, wobei die zweite Schicht eine Oxidschicht ist.

Gemäß einer beispielhaften Ausführungsform wird ein Werkzeug oder ein Rohling zur Verfügung gestellt, wobei das Werkzeug oder der Rohling zwei, drei, vier oder beliebig viele dritte Schichten umfasst, wobei eine dritte Schicht durch eine kathodische Reduktion oder Teilreduktion der darunterliegenden dritten Schicht herstellbar ist.

In einer weiteren Ausführungsform wird ein Werkzeug oder ein Rohling zur Verfügung gestellt, wobei die erste Schicht Titan, Niob, Aluminium oder eine Kombination dieser Metalle umfasst oder wobei die erste Schicht aus Titan oder Niob oder Aluminium oder einer Kombination dieser Metalle besteht.

Gemäß einem weiteren Ausführungsbeispiel wird ein Werkzeug oder ein Rohling zur Verfügung gestellt, wobei das Werkzeug oder der Rohling umfasst: eine vierte Schicht, herstellbar durch ein viertes Verfahren, wobei die vierte Schicht unterhalb der ersten Schicht angeordnet ist, wobei das vierte Verfahren ein Verfahren aus einer Gruppe von Verfahren ist, wobei die Gruppe umfasst: PVD-Verfahren, CVD-Verfahren und elektrophoretische Verfahren.

Gemäß einer beispielhaften Ausführungsform wird ein Verfahren zur Verfügung gestellt, wobei das erste Verfahren ein PVD-Verfahren, ein CVD-Verfahren oder ein elektrophoretisches Verfahren ist und wobei das zweite Verfahren eine anodische Oxidation ist.

In einer weiteren Ausführungsform wird ein Verfahren zur Verfügung gestellt, wobei das zweite Verfahren bei einer ersten Spannung und einer ersten Eintauchtiefe des Werkzeugs in ein Elektrolyt vorgenommen wird, wobei das Verfahren umfasst: Beschichten oder Nachbehandeln oder Modifizieren des Werkzeugs oder des Rohlings mit einer dritten Schicht, herstellbar durch ein drittes Verfahren, wobei das dritte Verfahren bei einer zweiten Spannung und einer zweiten Eintauchtiefe des Werkzeugs oder des Rohlings in das Elektrolyt vorgenommen wird, wobei die erste Spannung und die zweite Spannung unterschiedlich sind und wobei die erste Eintauchtiefe und die zweite Eintauchtiefe unterschiedlich sind.

Durch das Anlegen unterschiedlicher Spannungen an das elektrolytische Bad können darin eingetauchte Werkzeuge oder Rohlinge mit unterschiedlichen Farben bzw. Farbtönen versehen werden. Falls dasselbe Werkzeug oder derselbe Rohling mehrmals in das elektrolytische Bad getaucht wird und ferner hierbei das Werkzeug oder der Rohling unterschiedlich tief in das elektrolytische Bad getaucht wird, können, falls in der Elektrolysezelle mit unterschiedlichen Spannungen gearbeitet wird, am Werkzeug oder am Rohling farbige Ringe oder Schichten erzeugt werden. Dieser Vorgang kann beliebig oft wiederholt werden, wodurch eine Aneinanderreihung von Farbringen, Farbtonringen bzw. Farbschichten am Werkzeug oder am Rohling erzielt werden kann, die z.B. zur Codierung von Produktionscharge, Herstelljahr, Bezeichnung der Geometrie und/oder Anwendungsweise des Werkzeugs dienen kann.

Als eine Idee der Erfindung kann angesehen werden, Werkzeuge oder Rohlinge aufeinanderfolgenden Beschichtungs- bzw. Nachbehandlungs- bzw. Modifikationsverfahren zu unterziehen, um damit die Werkzeuge oder die Rohlinge beispielsweise mit unterschiedlichen Farben versehen zu können. Hierdurch können unterschiedliche Werkzeuge oder Rohlinge leichter unterschieden werden. Ferner kann durch einen Farbauftrag das einzelne Werkzeug oder der einzelne Rohling kodiert werden, wodurch direkt am Werkzeug oder am Rohling Informationen über das Werkzeug oder den Rohling abgelesen werden kann. Hierdurch wird die Prozesssicherheit erhöht, da die Information direkt am Werkzeug oder Rohling angebracht ist und daher nicht verloren oder vertauscht werden kann.

Die einzelnen Merkmale können selbstverständlich auch untereinander kombiniert werden, wodurch sich zum Teil auch vorteilhafte Wirkungen einstellen können, die über die Summe der Einzelwirkungen hinausgehen.

### KURZE BESCHREIBUNG DER ZEICHNUNGEN

Weitere Einzelheiten und Vorteile der Erfindung werden anhand der in den Zeichnungen dargestellten Ausführungsbeispiele deutlich. Es zeigen
- Fig. 1: einen Aufbau zur Durchführung des Verfahrens der anodischen Oxidation,
- Fig. 2: mehrere Werkzeuge,
- Fig. 3: mehrere Rohlinge zur Herstellung von Werkzeugen,
- Fig. 4: einen Schichtaufbau,
- Fig. 5: einen weiteren Schichtaufbau,
- Fig. 6: einen weiteren Schichtaufbau,
- Fig. 7: einen weiteren Schichtaufbau,
- Fig. 8: einen weiteren Schichtaufbau.

### DETAILLIERTE BESCHREIBUNG BEISPIELHAFTER AUSFÜHRUNGSFORMEN

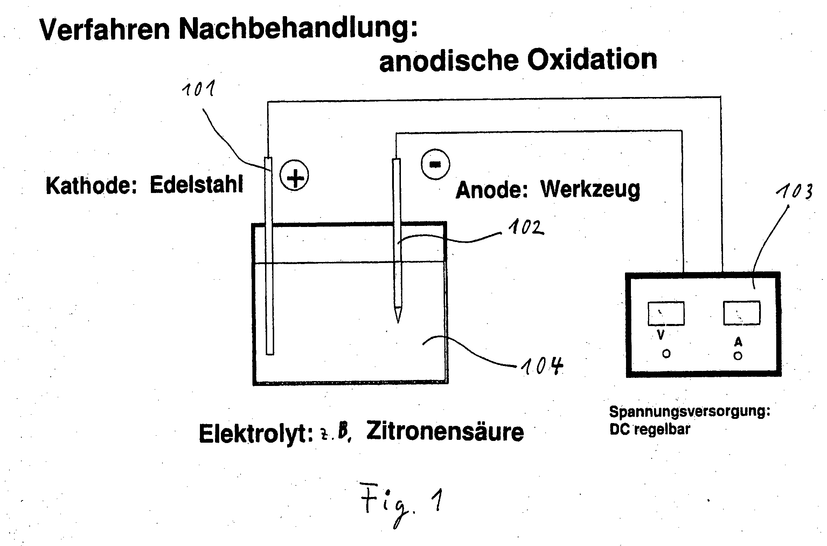

Fig. 1 zeigt einen Aufbau zur Durchführung einer anodischen Oxidation, wodurch Werkzeuge und/oder Rohlinge mit einer Oxidschicht versehen werden können. Hierzu wird das bereits z.B. mit einer Metallschicht beschichtete Werkzeug, das die Anode 102 darstellt, in einen Elektrolyten 104 eingetaucht, in dem sich ferner eine Kathode 101 befindet. Zwischen der Anode 102 und der Kathode 101 (z.B. ein Edelstahl) wird eine Spannung gelegt. Diese Spannung wird von einem Spannungsgenerator 103 erzeugt, wodurch sich über den Elektrolyten 104 ein geschlossener Stromkreis ergibt. Bei der vom Spannungsgenerator 103 angelegten Spannung kann es sich um eine geregelte, einstellbare Gleichspannung handeln, wodurch sich zwischen Anode 102 und Kathode 101 eine konstante, da geregelt, und änderbare Spannung ergibt. Als Elektrolyt können organische öder anorganische Säuren oder deren Salze oder Kombinationen dieser dienen, beispielsweise eine Schwefel-, Zitronen-, oder Chromsäure. Nach der anodischen Oxidation umgibt das Werkzeug und/oder den Rohling eine zumindest teilweise Oxidschicht. Diese kann z.B. als Schutzschicht gegen Korrosion und/oder Abrieb dienen. Bei einer anodischen Oxidation wird eine bestehende Metallschicht modifiziert, und zwar oxidiert, wodurch sich über der Metallschicht eine Oxidschicht ergibt. Erfindungsgemäß kann die bestehende Metallschicht oxidiert werden, um eine Farbwirkung erzielen zu können. Hierzu kann es genügen durch die anodische Oxidation eine Oxidschicht sehr geringer Schichtdicke entstehen zu lassen, die, da sie nur eine geringe Schichtdicke aufweist, als Schutzschicht nicht geeignet ist. Diese Oxidschicht kann beispielsweise eine Schichtdicke von ca. 10 nm aufweisen.

Alternativ kann eine Oxidschicht durch anodische Oxidation auf das blanke Werkzeug bzw. den blanken Rohling aufgebracht werden, wobei diese Oxidschicht eine Farbwirkung erzeugen kann.

Bevorzugt wird das Werkzeug oder der Rohling zunächst mit einer Metallschicht beschichtet. Hierzu kann z.B. ein Verfahren der physikalischen Gasabscheidung, bei denen eine Schicht durch Kondensation eines Dampfes eines Ausgangsmaterials auf einem Werkzeug gebildet wird, genutzt werden. Der Prozess der Gasabscheidung findet im Vakuum statt, wobei das zu verdampfende Material, das die Schicht auf dem Werkzeug bilden soll und zunächst in fester Form vorliegt, mit Laserstrahlen, magnetisch abgelenkten Ionen oder Elektronen beschossen wird oder einer Lichtbogenentladung ausgesetzt wird, wodurch das Ausgangsmaterial zumindest teilweise verdampft wird. Das verdampfte Material wird dann auf das zu beschichtende Material und/oder den Rohling geleitet und dort zur Kondensation gebracht, was zur Beschichtung des Werkzeugs und/oder des Rohlings führt. Mit der phsikalischen Gasabscheidung (PVD) können fast alle Metalle, Metallverbindungen und auch Kohlenstoff in sehr reiner Form abgeschieden werden. Führt man dem Prozess Reaktivgase wie Sauerstoff, Stickstoff oder Kohlenwasserstoffe zu, lassen sich auch Oxide, Nitride oder Carbide abscheiden. Weitere alternative Beschichtungsverfahren sind die CVD-Verfahren oder die elektrophoretische Verfahren. Diese erste Schicht kann als Funktionsschicht dienen und daher als Schutzschicht gegen Korrosion und/oder Abrieb vorgesehen sein. In diesem Fall wird die Schicht eine Schichtdicke von ca. 1µm bis 10 µm aufweisen. Die erste Schicht kann auch nur als Basis für eine nachfolgende anodische Oxidation dienen, wobei dann für diese erste Schicht eine geringe Schichtdicke von nur ca. 0,25 µm genügen kann.

Erfindungsgemäß können Werkzeuge oder Rohlinge zwei, drei oder beliebig vielen Beschichtungs- bzw. Modifikationsverfahren ausgesetzt werden, wobei mindestens zwei unterschiedliche Verfahren angewandt werden. Hierbei kann ein Beschichtungsverfahren auch die Oxidation einer Metallschicht und/oder die katodische Reduktion oder Teilreduktion einer Oxidschicht sein. In diesem Fall liegt eine Modifikation bzw. Nachbehandlung einer Metallschicht oder einer Oxidschicht vor.

Beispielsweise kann ein blankes Werkzeug oder ein blanker Rohling mit einer Oxidschicht sehr geringer Schichtdicke versehen werden, um eine Farbwirkung zu erzielen. Alternativ wird diese Oxidschicht in einem weiteren Verfahren einer kathodischen Reduktion oder Teilreduktion ausgesetzt, wodurch die Farbwirkung modifiziert werden kann.

In einer weiteren alternativen Ausführungsform wird zunächst ein PVD-Verfahren angewandt, um eine erste Schicht auf das Werkzeug oder den Rohling aufzutragen. Hierbei wird insbesondere eine Hartstoffschicht aufgetragen, die beispielsweise als Verschleißschutzschicht dienen kann. In derselben Beschichtungsanlage kann mit oder ohne zeitliche Unterbrechung ein weiteres Beschichtungsverfahren gefahren werden, wodurch auf der ersten Metallschicht eine weitere Metallschicht gebildet werden kann, die als Grundlage für eine anodische Oxidation dienen kann.

Nach Beschichtung mit einem PVD-Verfahren weist das Werkzeug oder der Rohling z.B. eine Metallschicht aus Titan, Niob, Aluminium oder ein ähnliches Metall bzw. eine Kombination verschiedener Metalle auf. Eine Abscheidung einer zu oxidierenden Metallschicht kann im PVD-Verfahren ohne oder mit nur einem geringen Anteil an einem Reaktivgas erfolgen. Durch eine nachfolgende anodische Oxidation kann sich je nach eingestellter Gleichspannung ein reproduzierbarer Farbton am Werkzeug oder am Rohling ergeben. Hierdurch können die Werkzeuge z.B. je nach Verwendungszweck (Bohrer, Fräser, Gewindeschneidwerkzeug) und/oder je nach Bearbeitungsschritt (Gewindebohrer unterschiedlicher Schneidstufen, Stufenbohrer unterschiedlicher Stufen) mit unterschiedlichen Farben bzw. Farbtönen versehen werden.

Erfindungsgemäß kann ein Werkzeug nach Beschichtung mit einem PVD-Verfahren mit sich wiederholenden Verfahren, insbesondere zunächst einer anodischen Oxidation und darauffolgenden kathodischen Reduktionen bzw. Teilreduktionen, modifiziert bzw. nachbehandelt werden, wodurch sich eine erste Oxidschicht und darüber liegende weitere reduzierte oder teilreduzierte Oxidschichten ergeben. Hierbei können auch wiederholte anodische Oxidationen am Werkzeug oder Rohling mit unterschiedlichen Spannungen vorgenommen werden, um z.B. eine farbliche Unterscheidung verschiedener Herstellschritte des Werkzeugs vornehmen zu können. Hierdurch kann bei sich wiederholenden Bearbeitungszyklen, z.B. bei einer Mehrzahl an Nachschleifvorgängen, dasselbe Werkzeug nach jedem einzelnen Nachschleifvorgang mit einer anderen Farbe versehen werden, um so den Stand der Bearbeitung bzw. die Häufigkeit der bislang erfolgten Nachbearbeitungszyklen am Werkzeug selbst kenntlich machen zu können. Ferner kann das Werkzeug oder der Rohling durch mehrere aufeinanderfolgende Verfahren anodisch oxidiert, reduziert oder teilreduziert werden, wobei die Eintauchtiefe des Werkzeugs sowie die Spannung, bei der die anodische Oxidation abläuft, variiert werden kann. Hierdurch können auf das Werkzeug oder den Rohling Farbringe und/oder Farbschichten aufgebracht werden. Durch die Mehrzahl der aufeinanderfolgenden anodischen Oxidationen können Sequenzen von Farbringen und/oder Farbschichten auf dem Werkzeug oder dem Rohling aufgebracht werden. Eine farbliche Unterscheidung kann ferner dazu genutzt werden, konstruktiv sehr ähnliche und daher ansonsten optisch schwer unterscheidbare Werkzeuge unterscheiden zu können.

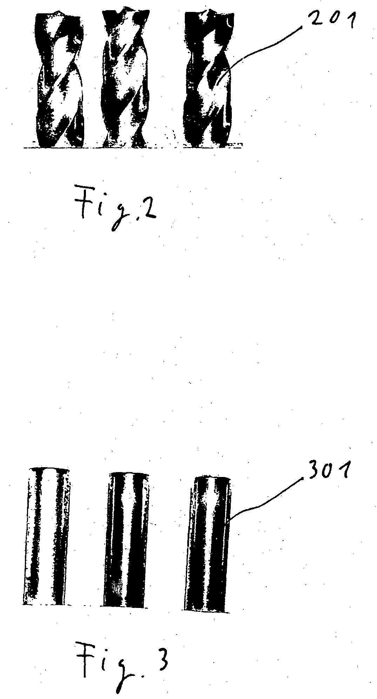

Fig. 2 zeigt drei Werkzeuge 201, die mit Farben bzw. Farbtönen zur Codierung bzw. Unterscheidung gegenüber anderen Werkzeugen mit z.B. ähnlicher Bohrgeometrie bzw. unterschiedlicher Bearbeitungs- bzw. Nachbearbeitungsstand versehen werden können. Die Werkzeuge 201 können dabei über ihre gesamte Oberfläche mit einem Farbton versehen werden. Alternativ kann der Farbauftrag nur auf die Schneiden des Werkzeugs 201, nur auf den schneidenden Abschnitt des Werkzeugs 201 oder nur auf den Schaft des Werkzeugs 201 erfolgen. Alternativ kann das komplette Werkzeug 201 oder beliebige Abschnitte oder Teile des Werkzeugs 201 eingefärbt werden (z.B. Kopfbeschichtung). Alternativ können beliebige Abschnitte oder Teile des Werkzeugs 201 mit unterschiedlichen Farbaufträgen versehen werden.

Fig. 3 zeigt drei Rohlinge 301 zur Herstellung von Werkzeugen, wobei die Rohlinge 301 z.B. zur Steuerung der weiteren Bearbeitung mit unterschiedlichen Farben versehen werden können. Die Rohlinge 301 können komplett oder abschnittsweise mit einem Farbauftrag versehen werden.

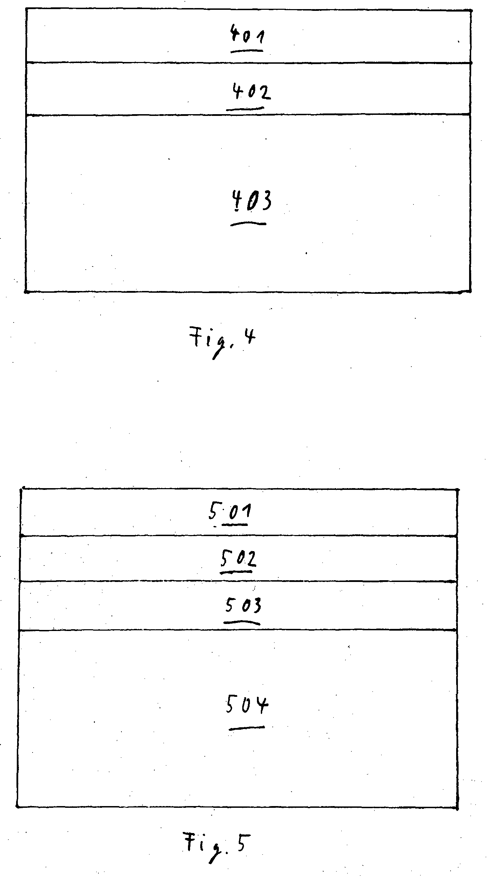

Fig. 4 zeigt einen Schichtaufbau mit einem Substrat (Träger) 403 und zwei weiteren Schichten 402 und 401. Das Substrat 403 stellt dabei das zu beschichtende Werkzeug oder den zu beschichtenden Rohling dar. Das Substrat 403 kann mit einer ersten Schicht 402 beschichtet werden, wobei diese Schicht 402 eine Metallschicht sein kann. Diese Metallschicht 402 kann durch ein PVD-Verfahren hergestellt werden und eine Schichtdicke von ca. 0,25 µm aufweisen. Diese Metallschicht kann ausschließlich als Ausgangsbasis für eine anodische Oxidation dienen. Durch diese nachfolgende anodische Oxidation kann eine weitere Schicht 401 erzeugt werden, die eine Schichtdicke von ca. 10 nm aufweisen kann, wobei die Schicht 401 zu einer Farbwirkung führen kann.

Fig. 5 zeigt einen Schichtaufbau mit einem Substrat (Träger) 504 und drei weiteren Schichten 503, 502 und 501. Auf das Substrat 504, das das zu beschichtende Werkzeug oder den zu beschichtenden Rohling darstellt, kann eine Metallschicht 503 aufgebracht werden, die eine Schichtdicke von ca. 0,25 µm aufweisen kann und die als Ausgangsbasis für eine anodische Oxidation dienen kann. Durch eine anodische Oxidation kann eine weitere Schicht 502 erzeugt werden, die eine erste Farbwirkung hervorrufen kann. Diese Schicht 502 kann eine Schichtdicke von nur ca. 10 nm aufweisen, was einigen Atomlagen entsprechen kann. Durch eine kathodische Reduktion oder Teilreduktion der Oxidschicht 502 kann eine weitere Schicht 501 erzeugt werden, die die bisherige Farbwirkung durch die Schicht 502 ändern kann. Diese nachträgliche Änderung der Farbwirkung durch kathodische Reduktion oder Teilreduktiön kann beliebig oft wiederholt werden, wodurch sich beliebig viele weitere Schichten ergeben. Die Schicht 501 kann wie die Schicht 502 eine Schichtdicke von ca. 10 nm aufweisen.

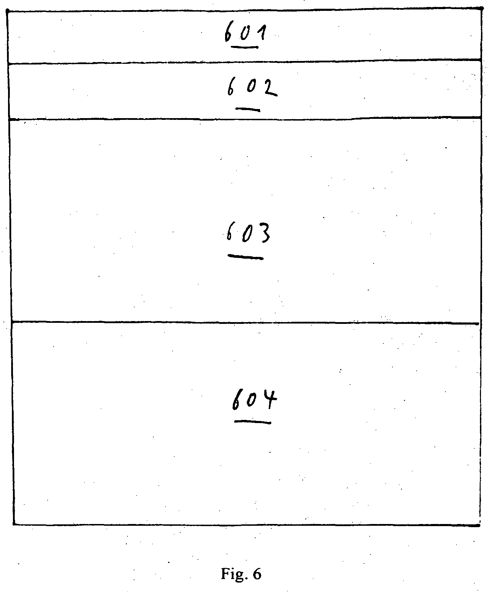

Fig. 6 zeigt einen Schichtaufbau, der dem Schichtaufbau nach Fig. 4 ähnelt, wobei allerdings zunächst auf das Substrat 604, das das Werkzeug oder den Rohling darstellt, eine Metallschicht 603 aufgetragen wird. Auf diese Schicht 603 wird eine weitere Metallschicht 602 und eine Oxidschicht 601 aufgebracht. Die Schichten 602 und 601 werden daher nicht wie in Fig. 4 auf das blanke Substrat 604 aufgebracht, sondern es wird eine Zwischenschicht 603 zwischen Substrat 604 und Metallschicht 602 angeordnet. Die Schicht 603 kann z.B. eine Hartstoffschicht sein, die als Verschleißschutzschicht vorgesehen ist und eine Schichtdicke von ca. 1µm bis 10µm aufweisen kann. Die Härte der Schicht 603 kann zwischen 2000 HV 0,005 bis 10.000 HV 0,005 liegen. Diese Funktionsschicht 403 kann aus Nitriden, Carbonitriden, Oxiden, Oxinitriden oder Oxicarbiden bestehen bzw. kann die Schicht 603 Nitride, Carbonitride, Oxide, Oxinitride öder Oxicarbide umfassen. Auf diese Schicht 603 kann eine weitere Schicht 602 aufgetragen werden, die eine Metallschicht sein kann und eine Schichtdicke von ca. 0,25 µm aufweisen kann. Diese Schicht 602 kann durch ein PVD-Verfahren, ein CVD-Verfahren oder eine elektrophoretische Abscheidung aufgetragen werden, wobei diese Schicht 602 als Ausgangsbasis für eine anodische Oxidation genutzt werden kann. Auf die Schicht 602 kann durch anodische Oxidation eine weitere Schicht 601 aufgebracht werden, die nur ca. 10 nm (z.B. mehrere Atomlagen) dick sein kann. Diese Schicht 601 stellt dann eine oxidierte Metallschicht dar, die eine Farbwirkung hervorrufen kann.

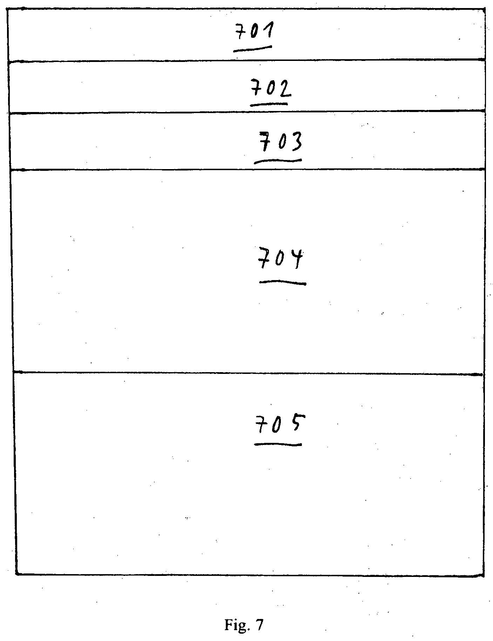

Fig. 7 zeigt einen Schichtaufbau, der dem Schichtaufbau nach Fig. 6 ähnelt, wobei eine zusätzliche Schicht 701 vorhanden ist, die durch kathodische Reduktion oder Teilreduktion der Oxidschicht 702 erzeugt werden kann. Hierdurch kann die Farbwirkung aufgrund der Oxidschicht 702 geändert oder modifiziert werde. Die Änderung der Farbwirkung kann beliebig oft wiederholt werden, wobei durch das mehrmalige kathodische Reduzieren oder Teilreduzieren weitere zusätzliche Schichten 701 auf das Werkzeug oder den Rohling aufgetragen werden. Die Schicht 701 kann eine Schichtdicke von ca. 10 nm aufweisen, was mehreren Atomlagen entsprechen kann. Das Bezugszeichen 705 bezeichnet das Substrat, also das zu beschichtende

Werkzeug oder der zu beschichtende Rohling. Die Schicht 704 ist eine Funktionsschicht, die z.B. dem Verschleißschutz dienen kann. Die Schicht 703 kann eine Metallschicht sein, z.B. aus Metallen der IV., V. oder VI. Nebengruppe des Periodensystems oder aus Legierungen von Metallen der IV., V. oder VI. Nebengruppe des Periodensystems mit Elementen der II. oder III. Hauptgruppe des Periodensystems. Diese Metallschicht 703 kann danach durch ein Oxidationsverfahren nachbehandelt werden, wodurch sich die Schicht 702 ergeben kann. Die Schicht 701 kann durch einen kathodischen Reduktions- oder Teilreduktionsschritt hergestellt werden. Die Reduktionsschritte können beliebig oft wiederholt werden, wodurch die Farbwirkung nachträglich beliebig oft abgeändert werden kann.

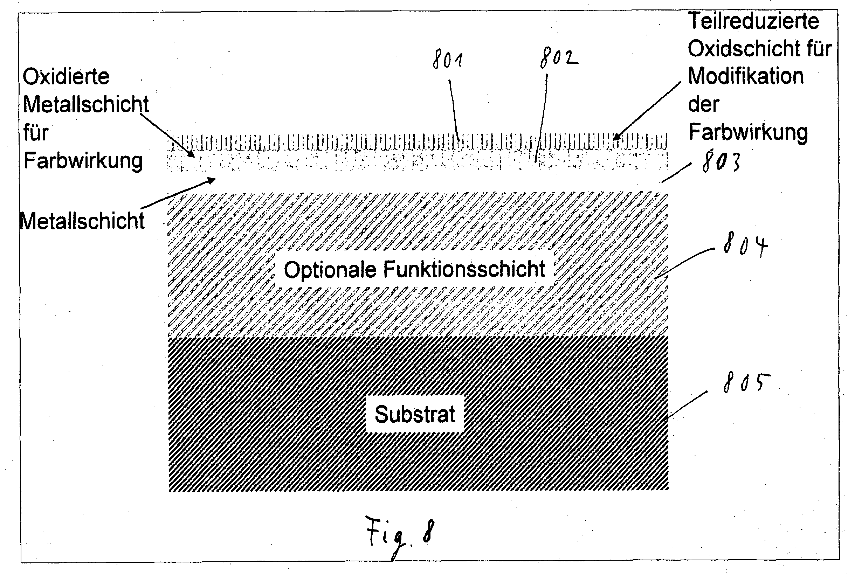

Fig. 8 zeigt eine Schichtenfolge mit einem Substrat (Träger) 805, auf das z.B. vier Schichten 804, 803, 802 und 801 aufgebracht sind. Auf das Substrat 805 kann eine optionale Funktionsschicht 804 aufgetragen werden. Diese Schicht kann eine Verschleißschutzschicht sein, die aus Nitriden, Carbonitriden, Oxiden, Oxinitriden oder Oxicarbiden besteht oder diese umfasst. Die Schicht 804 kann als Hartstoffschicht ausgebildet sein, die eine Härte von 2000 HV 0,005 bis 10.000 HV 0,005 aufweisen kann. Die Funktionsschicht 804 kann eine Dicke von 1 µm bis 10 µm aufweisen. Auf diese Schicht 804 kann eine Metallschicht 803 z.B. aus Metallen der IV., V. oder VI. Nebengruppe des Periodensystems oder aus Legierungen von Metallen der IV., V. oder VI. Nebengruppe des Periodensystems mit Elementen der II. oder III. Hauptgruppe des Periodensystems durch z.B. ein PVD-Verfahren, ein CVD-Verfahren oder ein elektrophoretisches Verfahren aufgetragen werden, wobei diese Metallschicht 803 eine Schichtdicke von ca. 0,25 µm aufweisen kann. Diese Schicht 803 kann mit einer Oxidschicht 802 durch eine anodische Oxidation überzogen werden, wobei die Schicht 802 zu einer Farbwirkung führen kann. Durch kathodische Reduktion bzw. Teilreduktion kann die Schicht 802 nachbehandelt werden, wodurch sich eine weitere Schicht 801 ergeben kann. Hierdurch kann die Farbwirkung geändert werden.

Es sei angemerkt, dass der Begriff "umfassen" weitere Elemente oder Verfahrensschritte nicht ausschließt, ebenso wie der Begriff "ein" und "eine" mehrere Elemente und Schritte nicht ausschließt.

Die verwendeten Bezugszeichen dienen lediglich zur Erhöhung der Verständlichkeit und sollen keinesfalls als einschränkend betrachtet werden, wobei der Schutzbereich der Erfindung durch die Ansprüche wiedergegeben wird.

### LISTE DER BEZUGSZEICHEN

- 101: Kathode
- 102: Anode
- 103: Spannungsgenerator
- 104: Elektrolyt
- 201: Werkzeug
- 301: Rohling
- 401: oxidierte Metallschicht
- 402: Metallschicht
- 403: Substrat
- 501: reduzierte oder teilreduzierte Oxidschicht
- 502: oxidierte Metallschicht
- 503: Metallschicht
- 504: Substrat
- 601: oxidierte Metallschicht
- 602: Metallschicht
- 603: Funktionsschicht
- 604: Substrat
- 701: reduzierte oder teilreduzierte Oxidschicht
- 702: oxidierte Metallschicht
- 703: Metallschicht
- 704: Funktionsschicht
- 705: Substrat
- 801: teilreduzierte Oxidschicht zur Modifikation der Farbwirkung
- 802: oxidierte Metallschicht für Farbwirkung
- 803: Metallschicht
- 804: Funktionsschicht
- 805: Substrat

## Patentansprüche

1. Werkzeug oder Rohling, wobei das Werkzeug oder der Rohling umfasst eine erste Schicht (803) und eine zweite Schicht (802), wobei die zweite Schicht (802) über der ersten Schicht (803) angeordnet ist und wobei, die erste Schicht (803) eine Metallschicht ist und die zweite Schicht (802) eine erste Oxidschicht (802) mit einer ersten Farbwirkung ist,
**dadurch gekennzeichnet, dass,**
die erste Oxidschicht (802) eine Schichtdicke von ca. 10 nm aufweist und wobei das Werkzeug oder der Rohling eine zweite Oxidschicht (801) umfasst, wobei sich die zweite Oxidschicht (801) durch kathodische Reduktion oder Teilreduktion der ersten Oxidschicht (802) ergibt, wobei die zweite Oxidschicht eine zweite Farbwirkung aufweist, wodurch zwei Oxidschichten mit unterschiedlichen Farbwirkungen vorliegen, und wobei sich eine resultierende Farbwirkung aus der ersten Farbwirkung und der zweiten Farbwirkung ergibt, wobei die zweite Oxidschicht direkt auf der ersten Oxidschicht angeordnet ist.

2. Werkzeug oder Rohling nach Anspruch 1, wobei die erste Schicht (803) Titan, Niob, Aluminium oder eine Kombination dieser Metalle umfasst oder wobei die erste Schicht (803) aus Titan oder Niob oder Aluminium oder einer Kombination dieser Metalle besteht.

3. Verfahren zur Herstellung eines Werkzeugs oder eines Rohlings, wobei das Verfahren die Schritte umfasst Beschichten des Werkzeugs oder des Rohlings mit einer ersten Schicht (803) herstellbar durch ein erstes Verfahren und
Beschichten oder Nachbehandeln oder Modifizieren des Werkzeugs oder des Rohlings mit einer zweiten Schicht (802) herstellbar durch ein zweites Verfahren, wobei das erste Verfahren unterschiedlich zum zweiten Verfahren ist, wobei die zweite Schicht (802) über der ersten Schicht (803) angeordnet ist und die erste Schicht (803) eine Metallschicht ist und die zweite Schicht (802) eine erste Oxidschicht zur Entwicklung einer ersten Farbwirkung ist,
Beschichten des Werkzeugs oder des Rohlings mit einer dritten Schicht, wobei die dritte Schicht eine zweite Oxidschicht (801) zur Entwicklung einer zweiten Farbwirkung ist,
**dadurch gekennzeichnet, dass,**
die erste Oxidschicht (802) eine Schichtdicke von ca. 10 nm aufweist, wobei sich die zweite Oxidschicht (801) durch kathodische Reduktion oder Teilreduktion der ersten Oxidschicht ergibt, wodurch zwei Oxidschichten mit unterschiedlichen Farbwirkunggen vorliegen, und wobei sich eine resultierende Farbwirkung aus der ersten Farbwirkung und der zweiten Farbwirkung ergibt.

4. Verfahren nach Anspruch 3, wobei das erste Verfahren ein PVD-Verfahren, ein CVD- Verfahren oder ein elektrophoretisches Verfahren ist und wobei das zweite Verfahren eine anodische Oxidation ist.

5. Verfahren nach Anspruch 4, wobei das zweite Verfahren bei einer ersten Spannung und einer ersten Eintauchtiefe des Werkzeugs in ein Elektrolyt vorgenommen wird, wobei das Verfahren umfasst:
Beschichten oder Nachbehandeln oder Modifizieren des Werkzeugs oder des Rohlings mit einer dritten Schicht (801), herstellbar durch ein drittes Verfahren, wobei das dritte Verfahren bei einer zweiten Spannung und einer zweiten Eintauchtiefe des Werkzeugs oder des Rohlings in das Elektrolyt vorgenommen wird, wobei die erste Spannung und die zweite Spannung unterschiedlich sind und wobei die erste Eintauchtiefe und die zweite Eintauchtiefe unterschiedlich sind.

## Claims

1. Tool or blank, wherein the tool or blank comprises a first layer (803) and a second layer (802), wherein the second layer (802) is located on top of the first layer (803) and wherein the first layer (803) is a metal layer and the second layer (802) is a first oxide layer (802) with a first colour effect,
**characterised in that**
the first oxide layer (802) has a coating thickness of approx. 10 nm, and wherein the tool or the blank includes a second oxide layer (801), wherein the second oxide layer (801) results from the cathodic reduction or partial reduction of the first oxide layer (802), wherein the second oxide layer has a second colour effect, whereby two oxide layers with different colour effects exist; and wherein a resulting colour effect results from the first colour effect and from the second colour effect, wherein the second oxide layer is located directly above the first oxide layer.

2. Tool or blank according to claim 1, wherein the first layer (803) comprises titanium, niobium, aluminium or a combination of these metals or wherein the first layer (803) consists of titanium, or niobium or aluminium or a combination of these metals.

3. Method for the fabrication of a tool or blank, wherein the method comprises the steps Coating of the tool or blank with a first layer (803) which can be produced by a first method and
coating or post-treatment or modification of the tool or of the blank with a second layer (802) which can be fabricated using a second method, wherein the first method is different from the second method, wherein the second layer (802) is located above the first layer (803) and the first layer is a layer of metal (803) and the second layer (802) is an oxide layer for the development of a first colour effect,
Coating of the tool or of the blank with a third layer, wherein the third layer is a second oxide layer (801) for the development of a second colour effect,
**characterised in that**
the first oxide layer (802) has a layer thickness of approx. 10 nm, wherein the second oxide layer (801) results from a cathodic reduction or partial reduction of the first oxide layer, whereby two oxide layers exist with different colour effects and wherein a resulting colour effect results from the first colour effect and the second colour effect.

4. Method according to claim 3 wherein the first method is a PVD method, a CVD method or an electrophoretic method and wherein the second method is an anodic oxidation.

5. Method according to claim 4, wherein the second method is performed using a first voltage and a first immersion depth of the tool in an electrolyte, wherein the method comprises
coating or post-treatment or modification of the tool or of the blank with a third layer (801), which can be produced by a third method, wherein the third method can be exercised with a second voltage and a second immersion depth of the tool or of the blank in the electrolyte, wherein the first voltage and the second voltage are different and wherein the first immersion depth and the second immersion depth are different.

## Revendications

1. Outil ou ébauche, ledit outil ou ladite ébauche comprenant une première couche (803) et une deuxième couche (802), la deuxième couche (802) étant superposée à la première couche (803) et la première couche (803) étant une couche métallique, et la deuxième couche (802) étant une première couche d'oxyde (802) avec un premier effet chromatique,
caractérisé(e) en ce que
la première couche d'oxyde (802) a une épaisseur de couche de 10 nm environ et en ce que l'outil ou l'ébauche comprend une deuxième couche d'oxyde (801), la deuxième couche d'oxyde (801) étant obtenue par réduction cathodique ou réduction partielle de la première couche d'oxyde (802), la deuxième couche d'oxyde ayant un deuxième effet chromatique, deux couches d'oxyde à effets chromatiques différenciés étant ainsi présentées ; et un effet chromatique résultant du premier effet chromatique et du deuxième effet chromatique, la deuxième couche d'oxyde étant directement superposée à la première couche d'oxyde.

2. Outil ou ébauche selon la revendication 1, où la première couche (803) comprend du titane, du niobium, de l'aluminium ou une combinaison de ces métaux, ou où la première couche (803) est en titane, en niobium ou en aluminium ou en une combinaison de ces métaux.

3. Procédé de fabrication d'un outil ou d'une ébauche, ledit procédé comprenant les étapes de revêtement de l'outil ou de l'ébauche avec une première couche (803) fabricable au moyen d'un premier procédé et
de revêtement, de post-traitement ou de modification de l'outil ou de l'ébauche avec une deuxième couche (802) fabricable au moyen d'un deuxième procédé, le premier procédé étant différent du deuxième procédé, la deuxième couche (802) étant superposée à la première couche (803) et la première couche (803) étant une couche métallique, et la deuxième couche (802) étant une première couche d'oxyde pour le développement d'un premier effet chromatique,
de revêtement de l'outil ou de l'ébauche avec une troisième couche, la troisième couche étant une deuxième couche d'oxyde (801) pour le développement d'un deuxième effet chromatique,
**caractérisé en ce que**
la première couche d'oxyde (802) a une épaisseur de couche de 10 nm environ, la deuxième couche d'oxyde (801) étant obtenue par réduction cathodique ou réduction partielle de la première couche d'oxyde, deux couches d'oxyde à effets chromatiques différenciés étant ainsi présentées, et un effet chromatique résultant du premier effet chromatique et du deuxième effet chromatique.

4. Procédé selon la revendication 3, où le premier procédé est un procédé PVD, un procédé CVD ou un procédé électrophorétique, et où le deuxième procédé est une oxydation anodique.

5. Procédé selon la revendication 4, où le deuxième procédé est exécuté avec une première tension et une première profondeur de plongée de l'outil dans un électrolyte, ledit procédé comprenant
le revêtement, le post-traitement ou la modification de l'outil ou de l'ébauche avec une troisième couche (801) fabricable au moyen d'un troisième procédé, ledit troisième procédé étant exécuté avec une deuxième tension et une deuxième profondeur de plongée de l'outil ou de l'ébauche dans l'électrolyte, la première tension et la deuxième tension étant différentes et la première profondeur de plongée et la deuxième profondeur de plongée étant différentes.
